## Europäisches Patentamt
## European Patent Office
## Office européen des brevets

(19)

(11) Veröffentlichungsnummer: **0 120 978**
**B1**

(12) # EUROPÄISCHE PATENTSCHRIFT

(45) Veröffentlichungstag der Patentschrift:
15.10.86

(51) Int. Cl.⁴: **H 03 H 17/02**

(21) Anmeldenummer: **83102968.1**

(22) Anmeldetag: **25.03.83**

(54) **Schaltungsanordnung zur Nachbildung resistiver Elementarzweitore zur Verwendung in Wellendigitalfiltern.**

(43) Veröffentlichungstag der Anmeldung:
**10.10.84 Patentblatt 84/41**

(45) Bekanntmachung des Hinweises auf die Patenterteilung:
**15.10.86 Patentblatt 86/42**

(84) Benannte Vertragsstaaten:
**AT BE CH DE FR GB IT LI LU NL**

(56) Entgegenhaltungen:
**DE-A-2 027 303**
**DE-B-2 418 923**
**US-A-3 919 671**
**US-A-3 967 099**

(73) Patentinhaber: **ANT Nachrichtentechnik GmbH, Gerberstrasse 33, D-7150 Backnang (DE)**

(72) Erfinder: **Scheuermann, Helmut, Dipl.- Ing., Schöntaler Strasse 55, D-7150 Backnang (DE)**

(74) Vertreter: **Schickle, Gerhard, Dipl.- Ing., ANT Nachrichtentechnik GmbH Patent- und Lizenzabteilung Gerberstrasse 33, D-7150 Backnang (DE)**

# 0 120 978

**Beschreibung**

Die Erfindung betrifft eine Schaltungsanordnung zur Nachbildung resistiver Elementarzweitore zur Verwendung in Wellendigitalfiltern.

Wellendigitalfilter sind bekanntgeworden beispielsweise durch die DE—A—20 27 303. Als Filtergrundschaltung dient eine übliche LC-Schaltung für Analogsignale, vorzugsweise in Abzweigschaltung, wobei Induktivitäten und Kapazitäten als laufzeitbehaftete Eintorschaltungen und Leitungselemente als laufzeitbehaftete Zweitorschaltungen ausgebildet sind und wobei Leerlauf, Kurzschluß, Widerstand, widerstandsfreie und -behaftete Quellen als laufzeitfreie Eintorschaltungen sowie Transformatoren, Gyratoren, Zirkulatoren als laufzeitfreie Mehrtorschaltungen ausgebildet sind und wobei die Eintor- und Mehrtorschaltungen mittels Adapter entsprechend zusammengeschaltet sind. Resistive zueinander duale Elementarzweitore gemäß Fig. 7a und b werden als Dreitor-Reihen- bzw. Paralleladapter mit einer Wellensenke am Ausgang des entsprechenden Tores realisiert, siehe Fig. 7c und d.

Aufgabe der vorliegenden Erfindung ist es, eine Schaltungsanordnung zu realisieren, die es gestattet, in wesentlich weniger aufwendiger Weise die Wellendigitalfilter zu realisieren, deren Transmittanz nicht auf dem Einheitskreis liegende Nullstellen aufweist.

Die Lösung erfolgt mit den im Kennzeichen der Patentansprüche 1 und 9 angegebenen Mitteln.

Zwar ist der Figur 15 der og. Offenlegungsschrift eine ähnliche digitale Filterstruktur zu entnehmen, doch stellt Fig. 15 eine mögliche Realisierung eines Zweitoradapters für die Zusammenschaltung von zwei Toren mit Torwiderständen R1 bzw. R2 gemäß Fig. 14a bzw. 14b dar.

Die erfindungsgemäße Schaltungsanordnung benötigt wesentlich weniger Additionsglieder und Multiplikatoren. Optimale Ausgestaltungen ergeben sich durch die Unteransprüche. Bei diesen optimalen Ausgestaltungen ist nur noch ein Multiplizierer erforderlich. Da Multiplizierer infolge der endlichen Signalwortlänge in rekursiven Filtern, zu denen auch die Wellendigitalfilter zu zählen sind, notwendigerweise ein Störgeräusch verursachen, wird auch das Rauschverhalten bei den erfindungsgemäßen Schaltungsanordnungen wesentlich günstiger. Die erfindungsgemäße Schaltungsanordnung gestattet in vorteilhafter Weise die Realisierung von Dämpfungsentzerrern.

Infolge der endlichen Signalwortlänge insbesondere bei schmalbandigen Entzerrern bzw. Filtern treten Instabilitäten auf, sogennante Grenzzyklusschwingungen, worunter parasitäre Schwingungen verstanden sind, deren Ursache in der Begrenzung der im Filter verfügbaren Stellenzahlen für die als elektrische Signalgrößen zu verarbeitende Zahlen liegt (Rundung eines Multiplikationsergebnisses auf die ursprüngliche Stellenzahl) und damit eine nichtlineare Auswirkung hat. Diese Grenzzyklen lassen sich im allgemeinen bei der Realisierung von Digitalfiltern, insbesondere bei der direkten Realisierung von höhergradigen Entzerrern und Filtern, nicht vollständig beseitigen (siehe H.W. Schüssler "Digitale Systeme zur Signalverarbeitung", Springerverlag Berlin, Heidelberg und New-York, 1973). Die erfindungsgemäße Schaltungsanordnung kann dagegen eine vollständige Stabilität gewährleisten, wenn die in der DE—B—24 18 923 vorgeschlagenen Maßnahmen getroffen werden. In den meisten Fällen jedoch sind diese Maßnahmen zur Stabilitätssicherung gar nicht notwendig, da die erfindungsgemäßen Entzerrer bzw. Filter durch die zusätzliche Einbeziehung von resistiven Zweitoren ein stark pseudopassives Verhalten aufweisen.

Es folgt nunmehr die Beschreibung anhand der Figuren. Die Fig. 1 bis 6 zeigen die Realisierung verschiedener resistiver Elementarzweitore mittels Wellenflußdiagramm. Die Fig. 7 zeigt, wie oben schon beschrieben, zwei zueinander duale resistive Elementarzweipole und ihre Realisierung gemäß dem Stande der Technik. Die Fig. 8 schließlich zeigt ein Ausführungsbeispiel für ein Wellendigitalfilter, wobei Fig. 8a das Referenzfilter und in Fig. 8b die zugehörige Realisierung des Wellendigitalfilters abgebildet sind.

In Tabelle 1 und Tabelle 2 finden sich eine Zusammenstellung der möglichen Realisierung von Widerstands- bzw. Leitwertelementarzweitoren, wobei in der linken Spalte die zugehörige Figur angegeben ist, in der nächstfolgenden Spalte die symbolische Schreibweise, in der nächstfolgenden Spalte die Werte für die Multipliziererkoeffizienten und schließlich in den beiden letzten Spalten die Matrizen Streumatrix S bzw. Transfermatrix T aufgelistet.

In Fig. 1 ist das Eingangstor a1, b1, und das Ausgangstor a2, b2, erkennbar. Die beiden Eingangssignale a1, a2 sind über einen ersten Summierer S1 zusammengefaßt und werden anschließend mittels zweier Multiplizierer negativ skaliert mit $-\alpha 1$ und $-\alpha 2$. Das mit $-\alpha 1$ skalierte Summensignal wird mittels eines weiteren Summierers mit dem Eingangssignal des Eingangstores a1 zusammengefaßt und dem Ausgangssignal b1 des Eingangstores zugeführt sowie mittels eines vierten Sumierers zusammen mit dem $-\alpha 2$ skalierten Summensignal zusammengefaßt und anschliessend mittels eines Inverters I invertiert als Ausgangssignal des Ausgangstores b2 zugeführt. Entsprechend der einzelnen Werte der Streumatrix S sind die Abhängigkeiten der beiden Ausgangssignale von den Eingangssignalen $S11 = 1 - \alpha 1$, $S12 = -\alpha 1$, $S_{21} = \alpha 2 - (1 - \alpha 1)$, und $S22 = \alpha 1 + \alpha 2$ aus der Fig. erkennbar. In entsprechender Weise sind die anderen Schaltungen aufgebaut. Die Fig. 2 zeigt dieselbe Schaltung nach Fig. 1, wobei lediglich Eingangs- und Ausgangstor vertauscht sind. In Fig. 3 werden die beiden Eingangssignale a1, a2 mittels eines ersten Summierers zusammengefaßt und anschließend negative skaliert mittels zweier Multiplizierer $-\alpha 1$ und $-\alpha 3$. Die so skalierten Summensignale werden anschließend jeweils mittels weiterer Summierer mit dem Eingangssignal a2 des Ausgangstores bzw. dem Eingangssignal a1 des Eingangstores zusammengefaßt und als Ausgangssignal b2 bzw. b1 dem Ausgangstor bzw. Eingangstor zugeführt. Die

2

**0 120 978**

Schaltungsanordnung nach Fig. 1.1 läßt sich aus der Schaltungsanordnung nach 1 ableiten, wenn Tor 1 reflexionsfrei gewählt, d.h. wenn für α1 der Wert 1 gesetzt wird. Die Fig. 2.2 zeigt die gleiche Schaltungsanordnung wie 1.1 nur mit vertauschten Toren.

In entsprechender Weise läßt sich die Realisierung nach Fig. 1.2 aus Fig. 1 ableiten, wenn α2 = 1 gesetzt wird. Die gleiche Anordnung zeigt die Fig. 2.1 mit vertauschten Toren. Die Fig. 3.1 ist aus der Fig. 3 erzeugbar für α1 = 1 (Tor 1 ist reflexsionsfrei), die Fig. 3.2 ist aus 3.1 erhältlich bei Toretausch.

Die Figuren 4, 5 und 6 zeigen die digital Realisierung der zu den Figuren 1 bis 3 dualen resistiven Elementarzweitore. In Fig. 4 werden das invertierte Eingangssignal a1 des Eingangstores und das Eingangssignal des Ausgangstores a2 mittels eines Summierers summiert, anschließend mit einem Multiplizierer −α1 skaliert und mittels eines weiteren Summierers mit dem mittels eines zweiten Multiplizierers −α2 skalierten Eingangssignal a2 des Ausgangstores zum Ausgangsignal b2 aufsummiert. Dieses Ausgangssignal b2 wird außerdem mit dem invertierten Eingangssignal a1 des Eingangstores mittels eines dritten Summierers zum Ausgangsignal b1 des Eingangstores zusammengefaßt. Die Schaltung nach Fig. 5 erhält man aus der von Fig. 4 durch Vertauschung von Ein- und Ausgangstor.

In der Fig. 6 ist erkennbar, daß die beiden Eingangssignale a1, a2, mittels zweier Inverter invertiert werden, anschliessend negativ skaliert mittels zweier Multiplizierer −α1 und −α3 und summiert werden. Das Summensignal wird mittels zweier Addierer einmal mit dem invertierten eingangssignal des Eingangstores zu dessen Ausgangsignal b1 und mit dem invertierten Eingangssignal a2 des Ausgangstores zu dessen Ausgangsignal b2 zusammengefaßt. Die Schaltungsanordnung nach 4.1 erhält man aus derjenigen nach Fig. 4 für α1 = 1. Die Anordnung nach Fig. 5.2 erhält man wiederum aus derjenigen von Fig. 4.1 durch Vertauschung der Tore. Die Anordnung von Fig. 4.2 erhält man ebenfalls aus derjenigen von Fig. 4, in dem α2 zu 1 gewählt wird. Durch Tortausch daraus wiederum die Anordnung nach Fig. 5.1. Die Anordnung nach Fig. 6.1 ist erhältlich aus derjenigen von Fig. 6, in dem α1 = 1 gewählt wird. Spiegelbildlich dazu wiederum ist die Fig. 6.2 (Eingangs- bzw. Ausgangstorvertauschung).

Fig. 8 schließlich zeigt ein Ausführungsbeispiel für ein Wellendigitalfilter, wobei Fig. 8a das analoge Referenzfilter und Fig. 8b die zugehörige digitale Realisierung zeigt.

3

TABELLE 1

| Fig. | Symbol | $\alpha$ | $\underset{\sim}{S}$ | $\underset{\sim}{T}$ |
|---|---|---|---|---|
| X | a1 →  R   → b2  <br> R1 — R — R2 <br> b1 ←  R   ← a2 | $\alpha1,\ \alpha2,\ \alpha3$ | $\begin{pmatrix} b1 \\ b2 \end{pmatrix} = \underset{\sim}{S} \begin{pmatrix} a1 \\ a2 \end{pmatrix}$ | $\begin{pmatrix} b1 \\ a1 \end{pmatrix} = \underset{\sim}{T} \begin{pmatrix} a2 \\ b2 \end{pmatrix}$ |
| 1 | " | $\alpha1 = \dfrac{2R1}{R1+R2+R}$ <br> $\alpha2 = \dfrac{R-(R1+R2)}{R1+R2+R}$ | $\begin{pmatrix} 1-\alpha1 & -\alpha1 \\ \alpha2-(1-\alpha1) & \alpha1+\alpha2 \end{pmatrix}$ | $\dfrac{1}{-\alpha+\alpha1+\alpha2}\begin{pmatrix} -\alpha2 & 1-\alpha1 \\ -\alpha1-\alpha2 & 1 \end{pmatrix}$ |
| 2 | " | $\alpha2 = \dfrac{R-(R1+R2)}{R1+R2+R}$ <br> $\alpha3 = \dfrac{2R2}{41+R2+R}$ | $\begin{pmatrix} \alpha2+\alpha3 & -1+\alpha2+\alpha3 \\ -\alpha3 & 1-\alpha3 \end{pmatrix}$ | $\dfrac{1}{\alpha3}\begin{pmatrix} \alpha2 & -\alpha2-\alpha3 \\ 1-\alpha3 & -1 \end{pmatrix}$ |
| 3 | " | $\alpha1 = \dfrac{2R1}{R1+R2+R}$ <br> $\alpha3 = \dfrac{2R2}{R1+R2+R}$ | $\begin{pmatrix} 1-\alpha1 & -\alpha1 \\ -\alpha3 & 1-\alpha3 \end{pmatrix}$ | $\dfrac{1}{\alpha3}\begin{pmatrix} 1-\alpha1-\alpha3 & -(1-\alpha1) \\ 1-\alpha3 & -1 \end{pmatrix}$ |
| 1.1 | R1=R2+R " | $\alpha2 = \dfrac{R}{R1} = \dfrac{R}{R2+R}$ | $\begin{pmatrix} 0 & -1 \\ \alpha2-1 & \alpha2 \end{pmatrix}$ | $\begin{pmatrix} -1 & 0 \\ \dfrac{\alpha2}{1-\alpha2} & \dfrac{1}{1-\alpha2} \end{pmatrix}$ |
| 1.2 | R=R1+R2 " | $\alpha1 = \dfrac{R1}{R} = \dfrac{R1}{R1+R2}$ | $\begin{pmatrix} 1-\alpha1 & -\alpha1 \\ \alpha1-1 & \alpha1 \end{pmatrix}$ | $\begin{pmatrix} \sigma & -1 \\ \dfrac{\alpha1}{1-\alpha1} & \dfrac{-1}{1-\alpha1} \end{pmatrix}$ |
| 2.1 | R+R1+R2 " | $\alpha3 = \dfrac{R2}{R} = \dfrac{R2}{R1+R2}$ | $\begin{pmatrix} \alpha3 & \alpha1-1 \\ -\alpha3 & 1-\alpha3 \end{pmatrix}$ | $\begin{pmatrix} \sigma & -1 \\ \dfrac{1-\alpha3}{\alpha3} & \dfrac{-1}{\alpha3} \end{pmatrix}$ |
| 2.2 | R2=R1+R " | $\alpha2 = \dfrac{R}{R2} = \dfrac{R}{R1+R}$ | $\begin{pmatrix} \alpha2 & \alpha2-1 \\ -1 & \sigma \end{pmatrix}$ | $\begin{pmatrix} \alpha2-1 & -\alpha2 \\ \sigma & -1 \end{pmatrix}$ |
| 3.1 | R1=R2+R " | $\alpha3 = \dfrac{R2}{R1} = \dfrac{R2}{R2+R}$ | $\begin{pmatrix} \sigma & -1 \\ -\alpha3 & 1-\alpha3 \end{pmatrix}$ | $\begin{pmatrix} -1 & \sigma \\ \dfrac{1-\alpha3}{\alpha3} & \dfrac{-1}{\alpha3} \end{pmatrix}$ |
| 3.2 | R2=R1+R " | $\alpha1 = \dfrac{R1}{R2} = \dfrac{R1}{R+R1}$ | $\begin{pmatrix} 1-\alpha1 & -\alpha1 \\ -1 & \sigma \end{pmatrix}$ | $\begin{pmatrix} -\alpha1 & \alpha1-1 \\ \sigma & -1 \end{pmatrix}$ |

TABELLE 2

| Fig. | Symbol | $\alpha$ | $\underset{\sim}{S}$ | $\underset{\sim}{T}$ |
|---|---|---|---|---|
| X | a1 → b2, G1 · G · G2, b1 ← a1 | $\alpha1,\ \alpha2,\ \alpha3$ | $\binom{b1}{b2} = \underset{\sim}{S}\binom{a1}{a2}$ | $\binom{b1}{a1} = \underset{\sim}{T}\binom{a2}{b2}$ |
| 4 | ,, | $\alpha1 = \dfrac{2G1}{G1+G2+G}$ $\alpha2 = \dfrac{G-(G1+G2)}{G1+G2+G}$ | $\begin{pmatrix} \alpha1-1 & 1-\alpha1-\alpha2 \\ \alpha1 & -\alpha1-\alpha2 \end{pmatrix}$ | $\dfrac{1}{\alpha1}\begin{pmatrix} -\alpha2 & \alpha1-1 \\ \alpha1+\alpha2 & 1 \end{pmatrix}$ |
| 5 | ,, | $\alpha2 = \dfrac{G-(G1+G2)}{G1+G2+G}$ $\alpha3 = \dfrac{2G2}{G1+G2+G}$ | $\begin{pmatrix} \alpha2-\alpha3 & \alpha3 \\ 1+\alpha2-\alpha3 & \alpha3-1 \end{pmatrix}$ | $\dfrac{1}{1+\alpha2+\alpha3}\begin{pmatrix} \alpha2 & \alpha2-\alpha3 \\ 1-\alpha3 & 1 \end{pmatrix}$ |
| 6 | ,, | $\alpha1 = \dfrac{2G1}{G1+G2+G}$ $\alpha3 = \dfrac{2G2}{G1+G2+G}$ | $\begin{pmatrix} \alpha1-1 & \alpha3 \\ \alpha1 & \alpha3-1 \end{pmatrix}$ | $\dfrac{1}{\alpha1}\begin{pmatrix} \alpha1+\alpha3-1 & \alpha1-1 \\ 1-\alpha3 & 1 \end{pmatrix}$ |
| 4.1 | G1=G2+G ,, | $\alpha2 = \dfrac{G}{G1} = \dfrac{G}{G2+G}$ | $\begin{pmatrix} \sigma & 1-\alpha2 \\ 1 & -\alpha2 \end{pmatrix}$ | $\begin{pmatrix} 1-\alpha2 & \sigma \\ \alpha2 & 1 \end{pmatrix}$ |
| 4.2 | G=G1+G2 ,, | $\alpha1 = \dfrac{G1}{G} = \dfrac{G1}{G1+G2}$ | $\begin{pmatrix} \alpha1-1 & 1-\alpha1 \\ \alpha1 & -\alpha1 \end{pmatrix}$ | $\begin{pmatrix} \sigma & -\dfrac{1-\alpha1}{\alpha1} \\ 1 & \dfrac{1}{\alpha1} \end{pmatrix}$ |
| 5.1 | G=G1+G2 ,, | $\alpha3 = \dfrac{G2}{G} = \dfrac{G2}{G1+G2}$ | $\begin{pmatrix} -\alpha3 & \alpha3 \\ 1-\alpha3 & \alpha3-1 \end{pmatrix}$ | $\begin{pmatrix} \sigma & -\dfrac{\alpha3}{1-\alpha3} \\ 1 & \dfrac{1}{1-\alpha3} \end{pmatrix}$ |
| 5.2 | G2=G1+G ,, | $\alpha2 = \dfrac{G}{G2} = \dfrac{G}{G1+G}$ | $\begin{pmatrix} -\alpha2 & 1 \\ 1-\alpha2 & \sigma \end{pmatrix}$ | $\begin{pmatrix} 1 & -\dfrac{\alpha2}{1-\alpha2} \\ \sigma & \dfrac{1}{1-\alpha2} \end{pmatrix}$ |
| 6.1 | G1=G2+G ,, | $\alpha3 = \dfrac{G2}{G1} = \dfrac{G2}{G2+G}$ | $\begin{pmatrix} \sigma & \alpha3 \\ 1 & \alpha3-1 \end{pmatrix}$ | $\begin{pmatrix} \alpha3 & \sigma \\ 1-\alpha3 & 1 \end{pmatrix}$ |
| 6.2 | G2=G1+G ,, | $\alpha1 = \dfrac{G1}{G2} = \dfrac{G1}{G1+G}$ | $\begin{pmatrix} \alpha1-1 & 1 \\ \alpha1 & \sigma \end{pmatrix}$ | $\begin{pmatrix} 1 & -\dfrac{1-\alpha1}{\alpha1} \\ \sigma & \dfrac{1}{\alpha1} \end{pmatrix}$ |

# 0 120 978

**Patentansprüche**

1. Schaltungsanordnung zur Nachbildung resistiver Elementarzweitore zur Verwendung in Wellendigitalfiltern, mit einem Wellenzweitor mit Ein- (a1, b2) und Ausgangstor (a2, b2), an denen jeweils Ein (a1, a2)- und Ausgangssignale (b1, b2) anstehen, dadurch gekennzeichnet, daß die Eingangssignale des Eingangs- und Ausgangstores mittels eines ersten Summiergliedes zusammengefaßt sind, daß das so entstehende Summensignal mittels eines ersten Multiplizierers negativ skaliert und mindestens einem der Tore mindestens als Teil seines Ausgangssignales zugeführt wird.

2. Schaltungsanordnung nach Anspruch 1, dadurch gekennzeichnet, daß ein zweiter Multiplizierer vorgesehen ist, durch den das Summensignal negativ skaliert ist, und daß dieses negativ skalierte Summensignal dem anderen Tor mindestens als Teil eines Ausgangssignales zugeführt wird.

3. Schaltungsanordnung nach Anspruch 1, dadurch gekennzeichnet, daß ein zweites Summierglied vorgesehen ist, durch welches das Eingangssignal des einen Tores mit dem skalierten Signal zum Ausgangssignal dieses einen Tores zusammengefaßt werden.

4. Schaltungsanordnung nach Anspruch 2 und 3, dadurch gekennzeichnet, daß ein drittes Summierglied vorgesehen ist, durch welches das Eingangssignal des anderen Tores mit dem ihm zugeführten skalierten Signal zum Ausgangssignal dieses Tores zusammengefaßt werden (Fig. 3).

5. Schaltungsanordnung nach Anspruch 2 und 3, dadurch gekennzeichnet, daß ein drittes Summierglied und ein Inverter vorgesehen sind, durch welch ersteres das Ausgangssignal des einen Tores mit dem skalierten Signal für das andere Tor zusammengefaßt und durch welch letzteren anschließend dieses zusammengefaßte Signal invertiert werden, was das Ausgangssignal des anderen Tores ergibt (Fig. 1 und Fig. 2).

6. Schaltungsanordnung nach Anspruch 3, dadurch gekennzeichnet, daß ein Inverter vorgesehen ist, durch den das Eingangssignal des einen Tores invertiert wird, und daß das so invertierte Eingangssignal das Ausgangssignal des anderen Tores ergibt (Fig. 3.1 und 3.2).

7. Schaltungsanordnung nach Anspruch 1, dadurch gekennzeichnet, daß ein weiteres Summierglied und ein erster Inverter vorgesehen sind, durch welch ersteres das skalierte Signal mit dem Eingangssignal des einen Tores zusammengefaßt und durch welch letzteren diese so zusammengefaßt Signal invertiert und dem anderen Tor als Ausgangssignal zugeführt werden, und daß ein zweiter Inverter vorgesehen ist, durch den das Ausgangssignal des anderen Tores invertiert und dem einen Tors als Ausgangssignal zugeführt wird (Fig. 1.1 und 2.2).

8. Schaltungsanordnung nach Anspruch 3, dadurch gekennzeichnet, daß ein Inverter vorgesehen ist, durch den das Ausgangssignal des einen Tores invertiert und dem anderen Tor als Ausgangssignal zugeführt wird (Fig. 1.2 und Fig. 2.1).

9. Schaltungsanordnung zur Nachbildung von resistiven Elementarzweitoren zur Verwendung in Wellendigitalfiltern, mit einem Wellenzweitor mit Ein (a1, b1)- und Ausgangstor (a2, b2), an denen jeweils Ein (a1, a2)- und Ausgangssignale (b1, b2) anstehen, dadurch gekennzeichnet, daß das eine Eingangssignal mittels eines ersten Multiplizierers negativ skaliert wird und aschließend zusammen mit dem anderen Eingangssignal einem ersten Summierglied zugeführt wird, daß das Summensignal mindestens einem der Tore mindestens als Teil seines Ausgangssignals dient.

10. Schaltungsanordnung nach Anspruch 9, dadurch gekennzeichnet, daß ein zweiter Multiplizierer vorgesehen ist, durch den das andere Eingangssignal vor der Summenbildung negativ skaliert wird.

11. Shaltungsanordnung nach Anspruch 9, dadurch gekennzeichnet, daß ein weiteres Summierglied vorgesehen ist, durch welches das negativ skalierte und das unskalierte Eingangssignal des einen Tores zusammengefaßt und dem anderen Tor als Ausgangssignal zugeführt werden (Fig. 4.1 und 5.2).

12. Schaltungsanordnung nach Anspruch 9, dadurch gekennzeichnet, daß ein Inverter vorgesehen ist, durch den das Eingangssignal des einen Tores vor der Skalierung invertiert wird, daß das invertierte negativ skalierte Eingangssignal dem anderen Tor als Ausgangssignal zugeführt wird und daß ein weiterer Summierer vorgesehen ist, durch den das Summensignal und das invertierte Eingangssignal des einen Tores zu seinem Ausgangssignal zusammengefaßt werden (Fig. 6.1 und 6.2).

13. Schaltungsanordnung nach Anspruch 1, dadurch gekennzeichnet, daß ein Inverter vorgesehen ist, durch den das Eingangssignal des einen Tores vor der Summenbildung invertiert wird, und daß ein zweites Summierglied vorgesehen ist, durch welche das unskalierte und negativ skalierte Summensignal zum Ausgangssignal dieses einen Tores zusammengefaßt werden (Fig. 4.2 und 5.1).

14. Schaltungsanordnung nach Anspruch 13, dadurch gekennzeichnet, daß ein weiterer Multiplizierer und ein weiteres Summierglied vorgesehen sind, durch welch ersteren das Eingangssignal des anderen Tores negativ skaliert wird und durch welch letzteren die beiden negativ skalierten Signale zum Ausgangssignal dieses anderen Tores zusammengefaßt werden (Fig. 4 und Fig. 5).

15. Schaltungsanordnung nach Anspruch 10, dadurch gekennzeichnet, daß beide Eingangssignale vor der negativen Skalierung mittels zweier Inverter invertiert werden und daß zwei weitere Summierglieder vorgesehen sind, durch die jeweils das invertierte Eingangssignal eines Tores und das Summensignal zum Ausgangssignal dieses Tores zusammengefaßt werden (Fig. 6).

6

# 0 120 978

## Revendications

1. Circuit pour la simulation de biportes élémentaires résistives destinées à des filtres d'ondes numériques, avec un biporte d'ondes comportant une porte d'entrée (a1, b1) et une porte de sortie (a2, b2), sur chacune desquelles sont appliqués des signaux d'entrée (a1, a2) et des signaux de sortie (b1, b2), ledit circuit étant caractérisé en ce que les signaux d'entrée des portes d'entrée et de sortie sont réunis par un premier sommateur; le signal somme ainsi obtenu est cadré négativement par un premier multiplicateur, puis appliqué à une des portes au moins, sous forme d'une partie au moins de son signal de sortie.

2. Circuit selon revendication 1, caractérisé en ce qu'un second multiplicateur est prévu pour le cadrage négatif du signal somme; et ledit signal somme cadré négativement est appliqué à l'autre porte, sous forme d'une partie au moins de son signal de sortie.

3. Circuit selon revendication 1, caractérisé par un second sommateur, qui réunit le signal d'entrée d'une porte et le signal cadré pour former le signal de sortie de ladite pourte.

4. Circuit selon revendications 2 et 3, caractérisé par un troisième sommateur, qui réunit le signal d'entrée de la seconde porte au signal cadré qui lui est appliqué pour former le signal de sortie de ladite porte.

5. Circuit selon revendications 2 et 3, caractérisé par un troisième sommateur et un inverseur, le sommateur réunissant le signal de sortie d'une porte au signal cadré pour l'autre porte et l'inverseur inversant ensuite ce signal résultant pour former le signal de sortie de l'autre porte (figures 1 et 2).

6. Circuit selon revendication 3, caractérisé en ce qu'un inverseur est prévu pour inverser le signal d'entrée d'un porte; et le signal d'entrée ainsi inversé forme le signal de sortie de l'autre porte (figures 3.1 et 3.2).

7. Circuit selon revendication 1, caractérisé en ce qu'un autre sommateur et un premier inverseur sont prévus, le sommateur réunissant le signal cadré et le signal d'entrée d'une porte, et l'inverseur inversant le signal résultant pour former le signal de sortie de l'autre porte; et un second inverseur est prévu, qui inverse le signal de sortie de l'autre porte pour former le signal de sortie de la première prote (figures 1.1 et 2.2).

8. Circuit selon revendication 3, caractérisé par un inverseur, qui inverse le signal de sortie d'une porte, puis l'applique à l'autre porte sous forme de signal de sortie (figures 1.2 et 2.1).

9. Circuit pour la simulation de biportes élémentaires résistives destinées à des filtres d'ondes numériques, avec une biporte d'ondes comortant une porte d'entrée (a1, b1) et une porte de sortie (a2, b2), sur chacune desquelles sont appliqués des signaux d'entrée (a1, a2) et de sortie (b1, b2), ledit circuit étant caractérisé en ce qu'un signal d'entrée est cadré négativement par un premier multiplicateur, puis appliqué avec l'autre signal d'entrée à un premier sommateur; et le signal somme constitue une partie au moins du signal de sortie d'une des portes au moins.

10. Circuit selon revendication 9, caractérisé par un second multiplicateur, qui cadre négativement le second signal d'entrée avant la sommation.

11. Circuit selon revendication 9, caractérisé par un autre sommateur, qu réunit le signal d'entrée cadré négativement et le même signal d'entrée non cadré d'une porte, pour former le signal de sortie de l'autre porte (figures 4.1 et 5.2).

12. Circuit selon revendication 9, caractérisé en ce qu'un inverseur est prévu pour inverser le signal d'entrée d'un porte avant le cadrage; le signal d'entrée cadré négativement et inversé est appliqué à l'autre porte, sous forme de signal de sortie; et un autre sommateur est prévu, qui réunit le signal somme et le signal d'entrée inversé d'une porte pour former son signal de sortie (figure 6.1 et 6.2).

13. Circuit selon revendication 1, caractérisé par un inverseur, qui inverse le signal d'entrée d'une porte avant la sommation; et par un second sommateur, qui réunit le signal somme cadré négativement et le même signal somme non cadré pour former le signal de sortie de ladite porte (figures 4.2 et 5.1).

14. Circuit selon revendication 13, caractérisé par un autre multiplicateur et un autre sommateur, le multiplicateur cadrant le signal d'entrée de la seconde porte et le sommateur réunissant les deux signaux cadrés négativement pour former le signal de sortie de ladite seconde porte (figures 4 et 5).

15. Circuit selon revendication 10, caractérisé en ce que les deux signaux d'entrée sont inversés par deux inverseurs, avant le cadrage négatif; et deux autres sommateurs sont prévus, réunissant chacun le signal d'entrée inversé d'une porte et le signal somme pour former le signal de sortie de ladite porte (figure 6).

## Claims

1. Circuit arrangement, for the simulation of resistive elementary two-port networks for use in digital wave filters, with a wave two-port with input port (a1, b1) and output port (a2, b2), at which input signals (a1, a2) and output signals (b1, b2) are present respectively, characterised thereby, that the input signals of the input and output port are combined by means of a first summing member, that the so arising sum signal is scaled negtively by means of a first multiplier and conducted to at least one of the ports as at least part of its output signal.

2. Circuit arrangement according to claim 1, characterised thereby, that a second multiplier is provided, by which the sum signal is scaled negatively, and that this negatively scaled sum signal is conducted to the other port as at least part of an output signal.

3. Circuit arrangement according to claim 1, characterised thereby, that a second summing member is provided, by which the input signal of the one port is combined with the scaled signal into the output signal of this one port.

4. Circuit arrangement according to claim 2 and 3, characterised thereby, that a third summing member is provided, by which the input signal of the other port is combined with the scaled signal conducted to it into the output signal of this port (Fig. 3).

5. Circuit arrangement according to claim 2 and 3, characterised thereby, that a third summing member and an inverter are provided, by the former of which the output signal of the one port is combined with the scaled signal for the other port and by the latter of which this combined signal is afterwards inverted, which results in the output signal of the other port (Fig. 1 and Fig. 2).

6. Circuit arrangement according to claim 3, characterised thereby, that an inverter is provided, by which the input signal of the one port is inverted, and that the so inverted input results in the output signal of the other port (Figs. 3.1 and 3.2).

7. Circuit arrangement according to claim 1, characterised thereby, that a further summing member and a first inverter are provided, by the former of which the scaled signal is combined with the input signal of the one port and by the latter of which this so combined signal is inverted and conducted to the other port as output signal, and that a second inverter is provided, by which the output signal of the other port is inverted and conducted to the one port as output signal (Figs. 1.1 and 2.2).

8. Circuit arrangement according to claim 3, characterised thereby, that an inverter is provided, by which the output signal of the one port is inverted and conducted to the other port as output signal (Figs. 1.2 and 2.1).

9. Circuit arrangement, for the simulation of resistive elementary two-port networks for use in digital wave filters, with a wave two-port with input port (a1, b1) and output port (a2, b2), at which input signals (a1, a2) and output signals (b1, b2) are present respectively, characterised thereby, that the one input signal is scaled negatively by means of a first multiplier and afterwards conducted together with the other input signal to a first summing member and that the sum signal serves at least one of the ports as at least part of its output signal.

10. Circuit arrangement according to claim 9, characterised thereby, that a second multiplier is provided, by which the other input signal is scaled negatively before the formation of the sum.

11. Circuit arrangement according to claim 9, characterised thereby, that a further summing member is provided, by which the negatively scaled and the unscaled input signals of the one port are combined and conducted to the other port as output signal (Figs. 4.1 and 5.2).

12. Circuit arrangement according to claim 9, characterised thereby, that an inverter is provided, by which the input signal of the one port is inverted before the scaling, that the inverted, negatively scaled signal is conducted to the other port as output signal and that a further summing member is provided, by which the sum signal and the inverted input signal of the one port are combined into its output signal (Figs. 6.1 and 6.2).

13. Circuit arrangement according to claim 1, characterised thereby, that an inverter is provided, by which the input signal of the one port is inverted before the formation of the sum, and that a second summing member is provided, by which the unscaled and the negatively scaled sum signals are combined into the output signal of this one port (Figs. 4.2 and 5.1).

14. Circuit arrangement according to claim 13, characterised thereby, that a further multiplier and a further summing member are provided, by the former of which the input signal of the other port is scaled negatively and by the latter of which both the negatively scaled signals are combined into the output signal of this other port (Fig. 4 and Fig. 5).

15. Circuit arrangement according to claim 10, characterised thereby, that both input signals are inverted by means of two inverters before the negative scaling and that two further summing members are provided, by which the inverted input signal of a respective port and the sum signal are combined into the output signal of this port (Fig. 6).